# EUROPEAN PATENT SPECIFICATION

(11) **EP 4 697 880 B1**
(45) Date of publication and mention of the grant of the patent: **11.11.2026**
(21) Application number: 24919135.4
(22) Date of filing: 22.07.2024
(51) Int. Cl.: H05K 7/20, H05K 9/00

(54) **ELECTRONIC DEVICE**
ELEKTRONISCHE VORRICHTUNG
DISPOSITIF ÉLECTRONIQUE

(30) Priority: 17.06.2024 CN 202410784089
(43) Date of publication of application: 18.02.2026
(60) Divisional application: 26189610.4 / 4 794 464
(73) Proprietor: Shanghai Moorewatt Energy Technology Co., Ltd., Shanghai 200131 (CN)
(72) Inventor: LAI, Guiren, Shanghai 200131 (CN)
(74) Representative: Bryn Aarflot AS
(86) International application number: PCT/CN2024/106776
(87) International publication number: WO 2025/260439

(56) References cited:
- CN-A- 116 546 791
- JP-A- 2010 011 671

## Description

### TECHNICAL FIELD

The present invention relates to the technical field of hardware heat dissipation, and in particular to an electronic device.

### BACKGROUND

A power converter can convert direction current (DC) into alternating current (AC). The DC terminal (i.e., input) of the power converter is connected to a DC source (a photovoltaic module), and the AC terminal (i.e., output) of the power converter can be connected to an AC grid and loads. In the power converter, components on a circuit board generate a lot of heat in operation. If the heat cannot be dissipated in time, the components on the circuit board will be damaged, thus causing the entire power converter to malfunction. Document JP2010011671A discloses a power convertor capable of suppressing heat generation in a drive circuit switching at a high speed even under a high-temperature environment. Document CN116546791A discloses a heat dissipation device including a housing, a heat conducting plate and a first heat dissipation fin arranged in the housing, a circuit board is arranged in the housing, a number of heat generating devices are arranged on the circuit board, and the heat conducting plate It is arranged between the circuit board and the first heat sink.

### SUMMARY

In view of this, it is necessary to provide an electronic device that can dissipate heat for a circuit board to address a problem of heat dissipation. The invention is set out in the appended set of claims.

The electronic device includes the housing, the heat spreader plate and the circuit board. The housing includes the upper housing and the lower housing. The lower housing, the heat spreader plate, the circuit board and the upper housing are arranged in sequence along the first direction. The projection of the heat spreader plate along the first direction covers at least a target region of the circuit board. In this solution, the heat spreader plate is arranged in the electronic device, and the projection of the heat spreader plate along the first direction covers at least the target region of the circuit board, so that the heat spreader plate can achieve the heat dissipation for the circuit board, and compared with the solution of arranging multiple heat spreader plates, the manufacturing costs can be reduced and the manufacturing process can be simplified.

In the above embodiments, the projection of the heat spreader plate along the first direction covers at least the target region of the circuit board. In this case, the heat spreader plate can be regarded as a shielding cover for the EMI generated by the circuit board, and can take an effect of shielding the EMI.

In the above embodiments, a loop is formed by the heat spreader plate, the circuit board, and parasitic capacitance between the heat spreader plate and the circuit board, and the EMI generated by the circuit board is confined in the loop, which can reduce the electromagnetic waves emitted outward, thereby restraining the EMI.

In the above embodiments, the heat spreader plate is a continuous whole heat spreader plate, and the EMI generated by the circuit board can circle in the plane formed by the heat spreader plate, which can reduce the electromagnetic waves emitted outward, thereby restraining the EMI.

### BRIEF DESCRIPTION OF THE DRAWINGS

FIG. 1 is a schematic structural view of an electronic device;
FIG. 2A is a first schematic view showing a circuit board 12 and a heat spreader plate 11;
FIG. 2B is a schematic view showing an arrangement of the heat spreader plate 11 and an electromagnetic interference (EMI) filter circuit;
FIG. 3 is a second schematic view showing the circuit board 12 and the heat spreader plate 11;
FIG. 4 is a schematic view of a partial structure of the electronic device;
FIG. 5A is a schematic view showing a fixing structure between a lower housing 14 and the heat spreader plate 11;
FIG. 5B is a partial enlarged view of a portion M in FIG. 5A;
FIG. 5C is a partial enlarged view of a portion N in FIG. 5A;
FIG. 5D is a partial enlarged view of a portion S in FIG. 5A;
FIG. 6 is a schematic structural view of a positioning member 56.

The drawings include: heat spreader plate 11, circuit board 12, upper housing 13, lower housing 14, first direction X, first dashed region 121, second dashed region 122, third dashed region 123, first-type through hole 31, second-type through hole 32, third-type through hole 33, fourth-type through hole 34, sixth-type through hole 35, fifth-type through hole 36, adhesive leakage hole 37, first coating region 421, second coating region 422, high-power consumption component region 431 in primary side region, high-power consumption component region 432 in secondary side region, first protrusion 441, second protrusion 442, EMI filter circuit region 45, first positioning post 51, first positioning hole 52, limiting hole 53, second positioning post 54, second positioning hole 55, positioning member 56, support portion 561, abutment portion 562.

### DETAILED DESCRIPTION OF THE EMBODIMENTS

In order to make the above objectives, features and advantages of the present disclosure clearer and better understood, specific implementations of the present invention are described in detail hereinafter with reference to the accompanying drawings. In the following description, many specific details are set forth to make the present invention to be fully understood.

In the description of the present invention, it should be understood that if the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. are used, the orientation or position relationships indicated by these terms are based on the orientation or position relationships shown in the accompanying drawings and are merely intended to facilitate the description of the present invention and simplify the description, rather than indicating or implying that the indicated device or element must have a particular orientation or be constructed and operated in a particular orientation, and therefore are not to be interpreted as limitations on the present invention.

In addition, if the terms "first" and "second" are used, these terms are used for descriptive purposes only but cannot be interpreted as indicating or implying relative importance or implicitly specifying the number of indicated technical features. Thus, the features defined as "first" and "second" may explicitly or implicitly include at least one of these features. In the description of the present invention, if the term "plurality" is described, the "plurality" means at least two, such as two, and three, etc., unless otherwise clearly and specifically defined.

In the present disclosure, unless otherwise clearly specified and limited, if the terms "mount", "connection", "communication", "fix", etc., are used, these terms should be understood in a broad sense, for example, may be a fixed connection or a detachable connection, or an integrated connection; or may be a mechanical connection or an electrical connection; or may be a direct connection or an indirect connection through an intermediate medium; or may be an internal communication between two elements or an interaction relationship between two elements, unless otherwise clearly defined. Those of ordinary skill in the art can understand the specific meanings of the above terms in the present disclosure according to specific situations.

In the present disclosure, unless otherwise clearly specified and limited, if there is a description that a first feature is "above" or "under" a second feature, etc., or similar description, it may mean that the first and second features are in direct contact, or the first and second features are in indirect contact through an intermediate medium. Moreover, the first feature being "on top of", "above" and "over" the second feature may mean that the first feature is directly above or obliquely above the second feature, or simply means that the horizontal height of the first feature is greater than that of the second feature. The first feature being "under", "beneath" and "below" the second feature may mean that the first feature is directly below or obliquely below the second feature, or simply means that the horizontal height of the first feature is less than the second feature.

It should be noted that if an element is referred to as being "fixed to" or "disposed on" another element, the element may be directly on the other element or there may be an intermediate element. If an element is considered to be "connected to" another element, the element may be directly connected to the other element or there may be an intermediate element as well. If any, the terms "vertical", "horizontal", "upper", "lower", "left", "right" and similar expressions used in this disclosure are for illustrative purposes only and do not represent the only embodiment.

A power converter is a power conversion device used to convert electrical energy from one form to another to achieve energy transmission and energy control under different power requirements. The power converter can be a micro-inverter, or an energy storage converter, etc. Exemplarily, the micro-inverter can convert direct current (DC) into alternating current (AC). The DC terminal (i.e., input) of the micro-inverter is connected to a DC source (e.g., a photovoltaic module), and the AC terminal (i.e., output) of the power converter can be connected to an AC grid and an AC device.

Exemplarily, in the micro-inverter, components on a circuit board generate a large amount of heat in operation. If the heat cannot be dissipated in time, the components on the circuit board will be damaged, thus causing the entire micro-inverter to malfunction.

In the present invention, the electronic device may be a power converter, for example, a micro-inverter, or a Power Conversion System (PCS) converter, etc. In an embodiment of the present disclosure, a heat spreader plate is arranged in the electronic device, so that the heat spreader plate can dissipate heat for the circuit board in time.

It should be noted that the heat spreader plate of the embodiment of the present invention can also be applied to, besides the power converter, any electronic device provided with a circuit board.

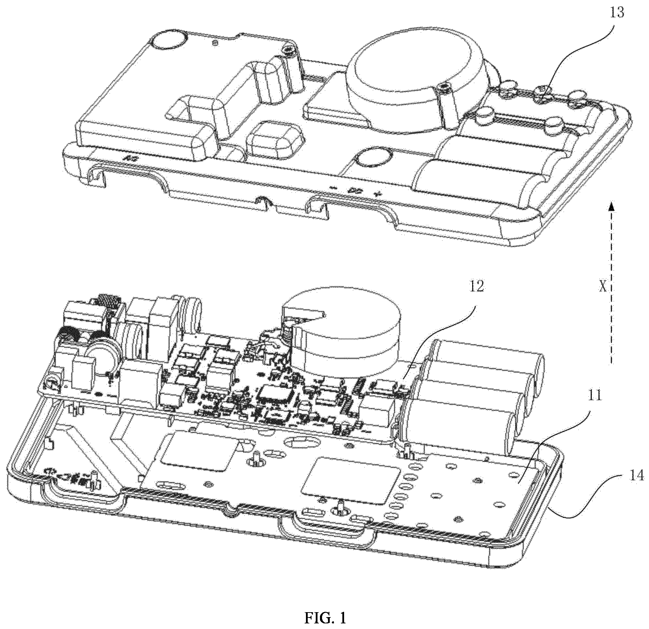

Referring to FIG. 1, FIG. 1 is a schematic structural view of an electronic device in an embodiment of the present invention. The electronic device includes: a housing, a heat spreader plate 11 and a circuit board 12. The housing includes an upper housing 13 and a lower housing 14. The lower housing 14, the heat spreader plate 11, the circuit board 12 and the upper housing 13 are arranged in sequence along a first direction X (i.e., a direction indicated by a dotted arrow in FIG. 1). A projection of the heat spreader plate 11 along the first direction X covers at least a target region of the circuit board 12.

As shown in FIG. 1, the electronic device is provided with the heat spreader plate 11, and the projection of the heat spreader plate 11 along the first direction X covers at least the target region of the circuit board 12, so that the heat spreader plate 11 can dissipate heat for the circuit board 12, and, compared with a solution of arranging multiple heat spreader plates, can reduce the manufacturing cost.

In some embodiments, the circuit board 12 may be a printed circuit board assembly (PCBA). The target region may be the entire region or a partial region of the circuit board 12. When the target region is the partial region of the circuit board 12, the projection of the heat spreader plate 11 along the first direction X can cover the partial region of the circuit board 12, thereby dissipating heat of the partial region on the circuit board, and compared with a solution that the entire region of the circuit board 12 is covered, the size of the heat spreader plate 11 may be reduced, the manufacturing cost may be reduced, and the manufacturing process may be simplified.

In the above embodiment, the projection of the heat spreader plate 11 along the first direction X covers at least the target region of the circuit board 12, and a loop is formed by the heat spreader plate 11, the circuit board 12, and parasitic capacitance between the heat spreader plate 11 and the circuit board 12, and electromagnetic interference (EMI) generated by the circuit board 12 is confined in the loop, which can reduce the electromagnetic waves emitted outward, thereby restraining the EMI. In addition, the heat spreader plate 11 is a continuous whole heat spreader plate, and the EMI generated by the circuit board 12 can be confined in the plane formed by the heat spreader plate 11, which can reduce the electromagnetic waves emitted outward, thereby restraining the EMI. In this case, the heat spreader plate 11 can be regarded as a shielding cover for the EMI generated by the circuit board 12, and can take an effect of shielding the EMI.

### Embodiment 1

The target region includes a first region on the circuit board 12, and components on the first region have a power consumption greater than a first preset threshold. On the circuit board 12, the components having the power consumption greater than the first preset threshold generate more heat due to a large power consumption, therefore the temperature of the first region will be relatively high, and the heat dissipation requirement thereof is also relatively high. The projection of the heat spreader plate 11 along the first direction covers the first region, which can make the heat dissipation effect of the first region better, thereby ensuring a normal operation of the components on the first region and prolonging the service life of the operating components.

On the circuit board 12, the components having power consumption greater than the first preset threshold can be defined as high-power consumption components, such as metal oxide semiconductor field effect transistors (MOSFETs). The first preset threshold can be set according to a relationship between power consumption and heat generation of a component in practice, as well as a requirement for heat dissipation in the embodiments of the present invention, which is not limited in the embodiments of the present invention.

It should be noted that the projection of the heat spreader plate 11 along the first direction X covering at least the target region of the circuit board 12 can be understood as follows: in embodiment 1, the projection of the heat spreader plate 11 along the first direction X not only covers the first region on the circuit board 12, but also can cover some other regions on the circuit board 12.

### Embodiment 2

The circuit board 12 includes a primary side region and a secondary side region. The primary side region is a region where a DC circuit of the circuit board 12 is located, and the secondary side region is a region where an AC circuit of the circuit board 12 is located.

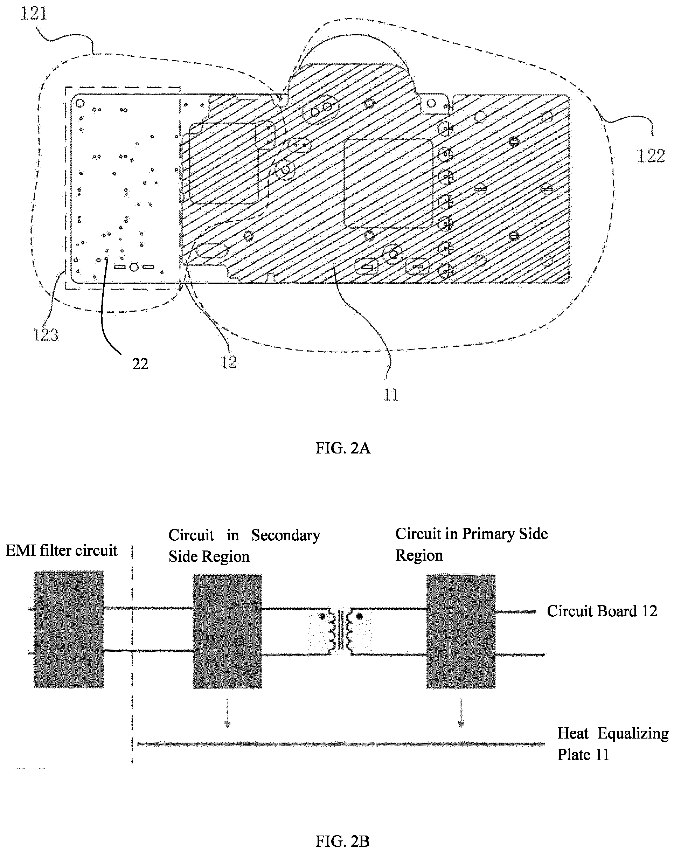

Exemplarily, FIG. 2A is a first schematic view showing a circuit board 12 and a heat spreader plate 11. As shown in FIG. 2A, a region within a first dashed region 121 on the circuit board 12 is the secondary side region, and a region within a second dashed region 122 on the circuit board 12 is the primary side region. The target region includes the primary side region on the circuit board 12, and a second region in the secondary side region on the circuit board 12. The components on the second region have a power consumption greater than a second preset threshold. The second region may be a region within the first dashed region 121 on the circuit board 12 shown in FIG. 2A and covered by the projection of the heat spreader plate 11.

It should be noted that the first dashed region 121 and the second dashed region 122 are exemplary region divisions. The boundary of the first dashed region 121 is not an exact boundary of the secondary side region, and the boundary of the second dashed region 122 is not an exact boundary of the primary side region either. The first dashed region 121 is only an exemplary region in which the secondary side region may be located, and the second dashed region 122 is only an exemplary region in which the primary side region may be located.

In some embodiments, the target region includes the second region in the secondary side region on the circuit board 12, where the components have the power consumption greater than the second preset threshold. The components in the second region on the circuit board 12 have the power consumption greater than the second preset threshold and generate more heat due to the large power consumption, therefore the temperature of the second region will be relatively high, and the heat dissipation requirement thereof is also relatively high. The projection of the heat spreader plate 11 along the first direction covers the second region, which can make the heat dissipation effect of the second region better, thereby ensuring a normal operation of the components on the second region and prolonging the service life of the operating components.

The second preset threshold can be set according to a relationship between power consumption and heat generation of a component in practice, as well as the requirement for heat dissipation in the embodiments of the present invention, which is not limited in the embodiments of the present invention.

### Embodiment 3

As shown in FIG. 2A, the target region excludes an EMI filter circuit region in the secondary side region on the circuit board. The EMI filter circuit region is a region on the circuit board 12, which is within the first dashed region 121 shown in FIG. 2A and is not covered by the projection of the heat spreader plate 11. The EMI filter circuit region may be within the third dashed region 123 shown in FIG. 2A.

It should be noted that the third dashed region 123 is an exemplary region division, and the boundary of the third dashed region 123 is not an exact boundary of the EMI filter circuit region, and the third dashed region 123 is only an exemplary region within which the EMI filter circuit region may be located.

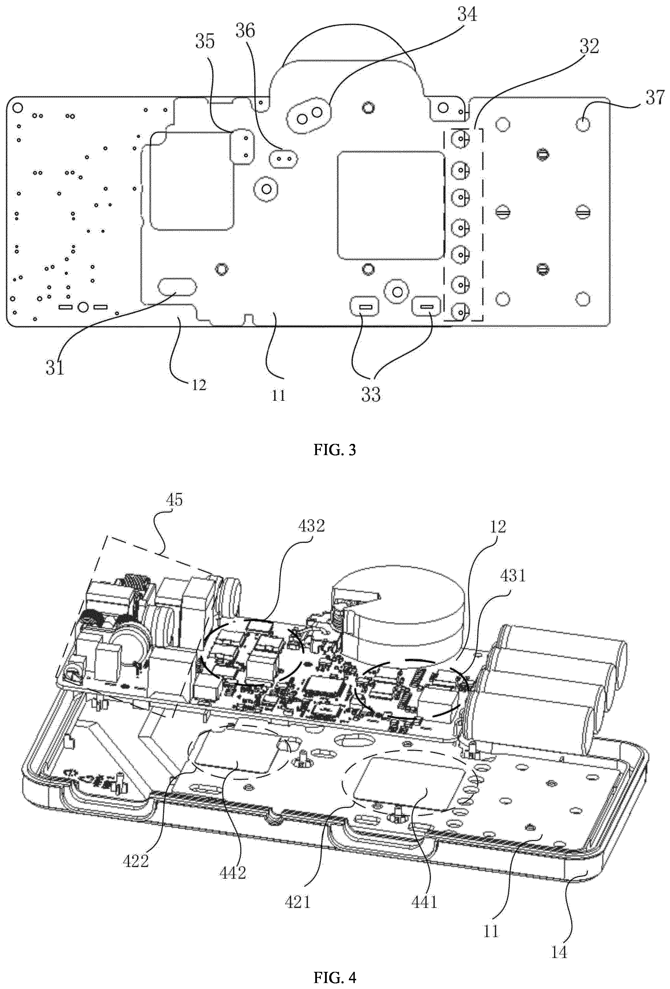

In some embodiments, illustratively, FIG. 2B is a schematic view showing an arrangement of the heat spreader plate 11 and an EMI filter circuit. As shown in FIG. 2B, the heat spreader plate 11 covers circuits in the primary side region and secondary side region of the circuit board 12, and the heat spreader plate 11 does not extend to the region (such as the EMI filter circuit region 45 shown in FIG. 4) where the EMI filter circuit is located, thereby preventing the heat spreader plate 11 from bypassing the EMI filter circuit, and improving the effect of restraining the EMI.

If the heat spreader plate 11 in FIG. 2B is configured to extend to such a position that the projection thereof covers the EMI filter circuit region, in this case, as there is parasitic capacitance between the heat spreader plate 11 and the circuit board 12, a low impedance channel will be formed between the parasitic capacitance and the heat spreader plate 11, so that the EMI generated in the secondary side region will be directly emitted through the low impedance channel without passing through the EMI filter circuit, and that the EMI filter circuit cannot achieve the effect of filtering, thus resulting in poor effect of restraining EMI noises. Based on such considerations, in the present invention, the heat spreader plate 11 is configured to not cover the EMI filter circuit region in the secondary side region, thereby improving the effect of restraining the EMI.

If the heat spreader plate 11 shown in FIG. 2A is configured to extend to such a position that the projection thereof covers the EMI filter circuit region, as shown in FIG. 2A, there are many component pins 22 in the EMI filter circuit region on the circuit board 12, so in order to meet the safety requirements, it is necessary to configure densely packed pin openings at positions on the heat spreader plate 11 corresponding to the EMI filter circuit region to avoid the large number of component pins 22. Configuring these pin openings will cause additional process costs, therefore, in the present invention, the heat spreader plate 11 is configured to not cover the EMI filter circuit region in the secondary side region, so as to reduce the process cost and ensure a good heat dissipation effect.

### Embodiment 4

A transformer may also be arranged in the target region, and the transformer is connected across the primary side region and the secondary side region.

In the above embodiment, a portion of the heat spreader plate 11 is configured to extend below a magnetic core of the transformer and connected across the primary side pins and the secondary side pins of the transformer, while covering the circuits in the primary side region and secondary side region, thus forming an electromagnetic shielding layer inside the electronic device, thereby effectively restraining the EMC noises.

It should be noted that the circuit board in the present invention is a circuit board assembly formed by installing various electronic components, such as resistors, capacitors, inductors, diodes, transistors, integrated circuits, etc., on a printed circuit board (PCB) through surface mount technology (SMT) or plug-in technology, and by performing a series of processes such as welding, cleaning, and testing.

In some embodiments, a first group of through holes are formed in the heat spreader plate 11, and the projections of the first group of through holes along the first direction X are located in the primary side region, and the first group of through holes are configured for insulation.

In some embodiments, a second group of through holes are formed in the heat spreader plate 11, and the projections of the second group of through holes along the first direction X are located in the secondary side region, and the second group of through holes correspond to the component pins in the secondary side region.

In some embodiments, the second group of through holes can be used for meeting safety requirements, and can be used to avoid component pins in the secondary side region on the circuit board 12.

In the present invention, the projection of the heat spreader plate 11 along the first direction covers the circuits in the primary side region, so the heat spreader plate 11 can be regarded as a part of the circuits in the primary side region. The safety standard requires that the components in the primary side region must be separated from the components in the secondary side region on the circuit board 12 by a certain distance (for example, 6.3 mm). In order to meet the safety requirements, openings are formed at positions on the heat spreader plate 11 corresponding to the component pins in the secondary side region, so that the heat spreader plate 11 (including the components in the primary side region) are separated from the components in the secondary side region by a safe distance.

If the heat spreader plate 11 is regarded as a part of the circuit of the secondary side region, then in order to meet the requirements, openings are necessarily formed on the heat spreader plate 11 at positions corresponding to the component pins in the primary side region. If relatively more openings are formed corresponding to the primary side region, a large continuous region cannot not be formed corresponding to the primary side region for heat dissipation, thus the heat dissipation effect would be poor and the manufacturing complexity would be relatively high. Therefore, the embodiment of the present invention does not adopt such a configuration, but adopts the above configuration where the heat spreader plate 11 is regarded as a part of the circuit of the primary side region, and openings are formed in the heat spreader plate 11 at positions corresponding to the component pins in the secondary side region.

Exemplarily, FIG. 3 is a second schematic view of the circuit board 12 and the heat spreader plate 11. As shown in FIG. 3, the first group of through holes include at least one of: a first-type through hole 31, a second-type through hole 32, a third-type through hole 33, a fourth-type through hole 34, or a fifth-type through hole 36. The projection of the first-type through hole 31 along the first direction X corresponds to a communication transformer pin in a power line communication (PLC). The projection of the second-type through hole 32 along the first direction X corresponds to a capacitor pin. The projection of the third-type through hole 33 along the first direction X corresponds to a connector. The projection of the fourth-type through hole 34 along the first direction X corresponds to a pin of the transformer in the primary side region. The projection of the fifth-type through hole 36 along the first direction X corresponds to a sampling pin of a current transformer CT.

Exemplarily, as shown in FIG. 3, the second group of through holes are formed in the heat spreader plate 11, and the second group of through holes include the sixth-type through hole 35. The projection of the sixth-type through hole 35 along the first direction X corresponds to a pin of the transformer in the secondary side region.

It should be noted that the through holes and the pins of the components shown in FIG. 3 are illustrative. In the embodiments of the present invention, the specific positions and quantities of the through holes in the heat spreader plate 11 and the specific positions and quantities of the pins on the circuit board 12 are not limited, and can be set according to actual needs.

In the present invention, the heat spreader plate 11 can be connected to the circuit board 12 through a thermal conductive adhesive filling the gap between the heat spreader plate 11 and the circuit board 12.

Exemplarily, the material of the thermal conductive adhesive may be silica gel, and the thermal conductive adhesive may have good thermal conductivity to conduct the heat of the circuit board 12 quickly to the heat spreader plate 11 to achieve good heat dissipation.

Exemplarily, the heat spreader plate 11 in the electronic device includes a thermal adhesive coating region, and a projection of the thermal conductive adhesive coating region along the first direction X coincides with the high-power consumption component regions.

The high-power consumption component regions may include the first region and/or the second region. High-power consumption components are arranged in the high-power consumption component region. Exemplarily, a component in the high-power consumption component region may be a MOSFET.

Exemplarily, FIG. 4 is a schematic view of a partial structure of the electronic device. As shown in FIG. 4, the heat spreader plate 11 in the electronic device includes the thermal adhesive coating region, and the thermal conductive adhesive coating region includes a first coating region 421 and a second coating region 422. The projection of the first coating region 421 along the first direction X coincides with the high-power consumption component region 431 in the primary side region, and the projection of the second coating region 422 along the first direction X coincides with the high-power consumption component region 432 in the secondary side region.

The high-power consumption component region 431 in the primary side region and the high-power consumption component region 432 in the secondary side region are two main high-heating regions. Thermal conductive adhesive is arranged in these two regions, so that not only the amount of thermal conductive adhesive can be saved, but also the heat in the high-heating regions can be prevented from being transferred to other low-heating regions to cause the components in other low-heating regions to be damaged.

In some embodiments, as shown in FIG. 4, a first protrusion 441 and a second protrusion 442 are disposed on the heat spreader plate 11. The first coating region 421 is disposed on the first protrusion 441, and the second coating region 422 is disposed on the second protrusion 442. The first protrusion 441 and the second protrusion 442 are protrusion structures integrally formed on the heat spreader plate 11.

In some embodiments, the heat spreader plate 11 may not be provided with any coating region, but only provided with a protrusion, and the projection of the protrusion along the first direction X coincides with the high-power consumption component region. Exemplarily, the protrusion disposed on the heat spreader plate 11 may be the first protrusion 441 and/or the second protrusion 442 as shown in FIG. 4, and the high-power consumption component region may be the high-power consumption component region 431 in the primary side region and/or the high-power consumption component region 432 in the secondary side region shown in FIG. 4. The protrusion may not be coated with any thermal conductive adhesive.

In the above embodiments, the protrusions (such as the first protrusion 441 and/or the second protrusion 442) are disposed on the heat spreader plate 11, so that the protrusions can be better in contact with the circuit board 12 (or the high-power consumption component region on the circuit board 12, such as the high-power consumption component region 431 in the primary side region and/or the high-power consumption component region 432 in the secondary side region), and can conduct the heat of the circuit board 12, thereby increasing a heat-conducting volume of the heat spreader plate 11, and achieving a better heat dissipation effect.

In some embodiments, a thickness of the heat spreader plate 11 is greater than or equal to 0.5 mm.

The heat spreader plate 11 is configured to have a relatively large thickness (i.e., greater than 0.5 mm), so that the heat dissipation effect thereof can be better.

In some embodiments, the heat spreader plate 11 is made of metal material. The heat spreader plate 11 can be made of a whole piece of metal material, and the whole piece of metal plate makes the manufacturing process relatively simple, thus saving manufacturing costs. The heat spreader plate 11 can be an aluminum plate or a copper plate. Since metal material has good thermal conductivity, the heat spreader plate 11 made of metal material can better dissipate heat for the circuit board. Since the metal material also has good electrical conductivity, the heat spreader plate 11 made of metal material enables the EMI (an electromagnetic wave) to form a closed loop on the heat spreader plate 11, thereby reducing the electromagnetic waves emitted outward, and improving the effect of restraining EMI.

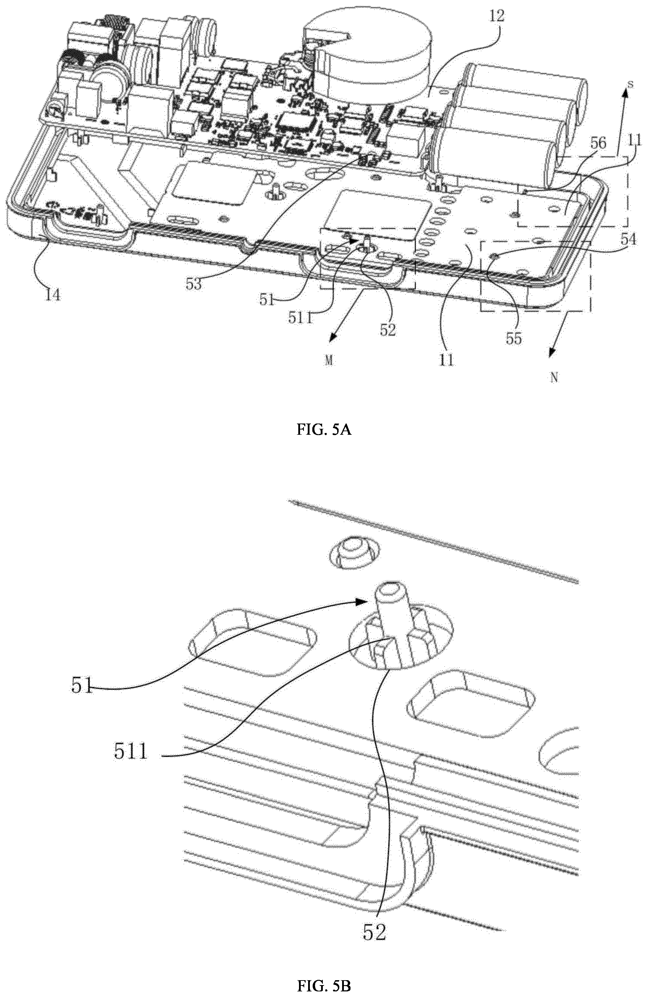

Exemplarily, FIG. 5A is a schematic view showing a fixing structure between a lower housing 14 and a heat spreader plate 11. As shown in FIG. 5A, a first positioning post 51 is disposed on one side of the lower housing 14 proximate to the heat spreader plate 11 and is adapted to extend along the first direction X. A first positioning hole 52 is formed in the heat spreader plate 11, a limiting hole 53 is formed in the circuit board 11, and the first positioning post 51 passes through the first positioning hole 52 and the limiting hole 53 in sequence.

In some embodiments, the first positioning post 51 includes a support pedestal 511, the circuit board 12 is supported on the support pedestal 511, and a height of the support pedestal 511 is greater than the thickness of the heat spreader plate 11.

Exemplarily, the support pedestal 511 may be in a cross shape, and the support pedestal 511 may be configured not only for positioning the heat spreader plate 11, but also for positioning the circuit board 12.

Exemplarily, the support pedestal 511 may be 1 mm higher than the heat spreader plate 11, so that the distance between the heat spreader plate 11 and the circuit board 12 is 1 mm, allowing for coating the thermal conductive adhesive.

In the above embodiments, the first positioning post 51 is configured to fix the heat spreader plate 11, support the circuit board 12, and restrain a lateral movement of the circuit board 12.

In some embodiments, a second positioning post 54 is disposed on the lower housing 14, a second positioning hole 55 is formed on the heat spreader plate 11, the second positioning post 54 is adapted to be inserted into the second positioning hole 55, and a height of the second positioning post 54 is the same as the thickness of the heat spreader plate 11.

In the above embodiment, the second positioning post 54 can be configured to restrain a lateral movement of the heat spreader plate 11.

In some embodiments, as shown in FIG. 5A, the lower housing 14 is further provided with a plurality of positioning members 56 arranged along an edge of the heat spreader plate 11.

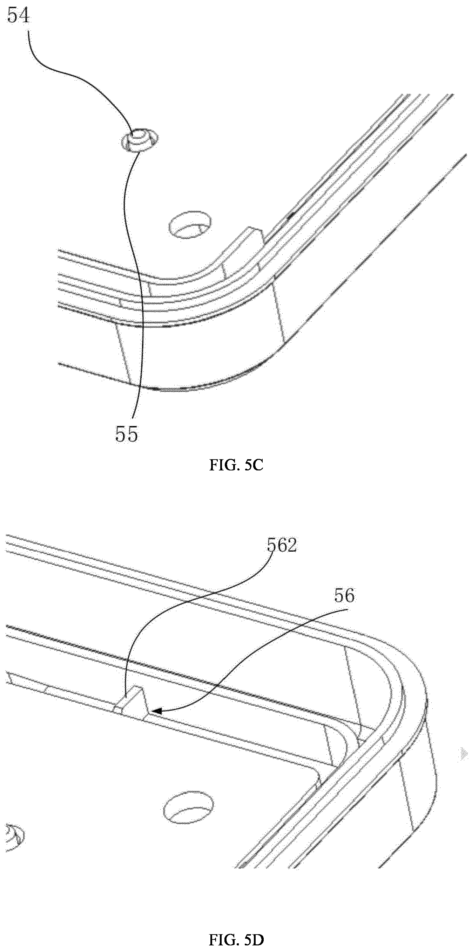

FIG. 5B is a partial enlarged view of a portion M in FIG. 5A, FIG. 5C is a partial enlarged view of a portion N in FIG. 5A, and FIG. 5D is a partial enlarged view of a portion S in FIG. 5A. As can be seen from FIG. 5D, each positioning member 56 can include an abutment portion 562, and the abutment portion 562 is adapted to abut against an outer side wall of the heat spreader plate 11. A fixing structure between the lower housing 14 and the circuit board 11 can be seen from FIG. 5A, FIG. 5B, FIG. 5C and FIG. 5D.

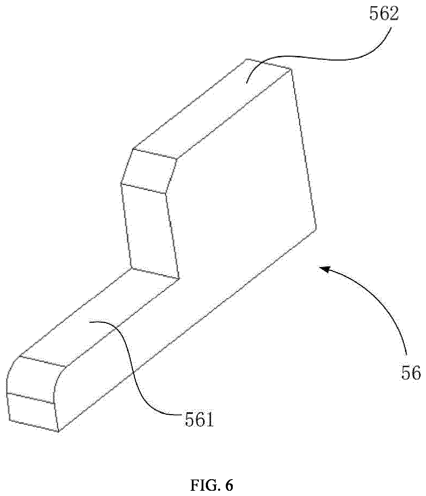

Exemplarily, FIG. 6 is a schematic structural view of a positioning member 56. As shown in FIG. 6, the positioning member 56 may include a support portion 561 and the abutment portion 562 connected to each other. The heat spreader plate 11 is supported on the support portion 561, and the outer side wall of the heat spreader plate 11 abuts against the abutment portion 562.

The support portion 561 is adapted to support the heat spreader plate 11. The abutment portion 562 is adapted to abut against an edge of the heat spreader plate 11 to restrain a lateral movement of the heat spreader plate 11.

In some embodiments, the height of the abutment portion 562 is greater than the thickness of the heat spreader plate 11, thus restraining the lateral movement of the heat spreader plate 11.

In some embodiments, as shown in FIG. 3, an adhesive leakage hole 37 is formed in the heat spreader plate 11. Six adhesive leakage holes are shown in FIG. 3 exemplarily, and the quantity of adhesive leakage holes 37 may be set as required in practice. The adhesive leakage hole 37 is configured to allow adhesive to quickly flow through the heat spreader plate 11.

The adhesive is used for sealing all components between the upper housing 13 and the lower housing 14 to prevent moisture from affecting the components. The adhesive leakage hole 37 allows the adhesive flowing to the heat spreader plate 11 to flow through the heat spreader plate 11 quickly, thereby ensuring that the adhesive flows to all positions, so that the adhesive can be more evenly distributed in the housing without generating bubbles.

## Claims

1. An electronic device, wherein the electronic device comprises a housing, a heat spreader plate (11) and a circuit board (12);
the housing comprises an upper housing (13) and a lower housing (14); the lower housing (14), the heat spreader plate (11), the circuit board (12) and the upper housing (13) are arranged in sequence along a first direction (X); and
a projection of the heat spreader plate (11) along the first direction (X) covers at least a target region of the circuit board (12);
wherein the circuit board (12) comprises a primary side region and a secondary side region; the primary side region is a region where a DC circuit of the circuit board (12) is located, and the secondary side region is a region where an AC circuit of the circuit board (12) is located;
the target region comprises:
a first region on the circuit board (12), wherein components on the first region have a power consumption greater than a first preset threshold;
the primary side region on the circuit board (12), and
a second region in the secondary side region, wherein components on the second region have a power consumption greater than a second preset threshold;
the heat spreader plate (11) is a continuous whole heat spreader plate and made of metal material;
a first group of through holes are formed in the heat spreader plate (11), and projections of the first group of through holes along the first direction (X) are located in the primary side region, and the first group of through holes are configured for insulation;
the first group of through holes comprise a fourth-type through hole (34) and at least one of: a first-type through hole (31), a second-type through hole (32), a third-type through hole (33), or a fifth-type through hole (36);
a projection of the first-type through hole (31) along the first direction (X) corresponds to a communication transformer pin in a power line communication (PLC);
a projection of the second-type through hole (32) along the first direction (X) corresponds to a capacitor pin;
a projection of the third-type through hole (33) along the first direction (X) corresponds to a connector;
a projection of the fourth-type through hole (34) along the first direction (X) corresponds to a pin of the transformer in the primary side region;
a projection of the fifth-type through hole (36) along the first direction (X) correspond to a sampling pin of a current transformer (CT);
a second group of through holes are formed in the heat spreader plate (11), projections of the second group of through holes along the first direction (X) are located in the secondary side region, and the second group of through holes correspond to component pins in the secondary side region, so that the components on the primary side region are separated from the components on the secondary side region by a safe distance; and
the second group of through holes comprise a sixth-type through hole (35); and a projection of the sixth-type through hole (35) along the first direction (X) corresponds to a pin of the transformer in the secondary side region.

2. The electronic device according to claim 1, wherein an electromagnetic interference (EMI) filter circuit region (45) in the secondary side region on the circuit board (12) is located outside the target region.

3. The electronic device according to claim 1, wherein a transformer is arranged in the target region, and the transformer is connected across the primary side region and the secondary side region.

4. The electronic device according to claim 1, wherein the heat spreader plate (11) comprises a thermal conductive adhesive coating region, and a projection of the thermal conductive adhesive coating region along the first direction (X) coincides with high-power consumption component regions.

5. The electronic device according to claim 4, wherein the thermal conductive adhesive coating region comprises a first coating region (421) and a second coating region (422);
a projection of the first coating region (421) along the first direction (X) coincides with a high-power consumption component region (431) in the primary side region; and
a projection of the second coating region (422) along the first direction (X) coincides with a high-power consumption component region (432) in the secondary side region.

6. The electronic device according to claim 5, wherein a first protrusion (441) and a second protrusion (442) are disposed on the heat spreader plate (11); the first coating region (421) is disposed on the first protrusion (441), and the second coating region (422) is disposed on the second protrusion (442).

7. The electronic device according to claim 1, wherein the heat spreader plate (11) is provided with a protrusion, and a projection of the protrusion along the first direction (X) coincides with a high-power consumption component region.

8. The electronic device according to claim 1, wherein a thickness of the heat spreader plate (11) is greater than or equal to 2 mm.

9. The electronic device according to claim 1, wherein a first positioning post (51) is disposed on one side of the lower housing (14) proximate to the heat spreader plate (11) and is adapted to extend along the first direction (X); a first positioning hole (52) is formed in the heat spreader plate (11), a limiting hole (53) is formed in the circuit board (12), and the first positioning post (51) is adapted to pass through the first positioning hole (52) and the limiting hole (53) in sequence.

10. The electronic device according to claim 9, wherein the first positioning post (51) comprises a support pedestal (511), the circuit board (12) is supported on the support pedestal (511), and a height of the support pedestal (511) is greater than a thickness of the heat spreader plate (11).

11. The electronic device according to claim 1, wherein a second positioning post (54) is disposed on the lower housing (14), a second positioning hole (55) is formed on the heat spreader plate (11), the second positioning post (54) is adapted to be inserted into the second positioning hole (55), and a height of the second positioning post (54) is the same as a thickness of the heat spreader plate (11).

## Patentansprüche

1. Elektronische Vorrichtung, wobei die elektronische Vorrichtung ein Gehäuse, eine Hitzeverteilungsplatte (11) und eine Leiterplatte (12) umfasst;
das Gehäuse ein Obergehäuse (13) und ein Untergehäuse (14) umfasst; das Untergehäuse (14), die Hitzeverteilungsplatte (11), die Leiterplatte (12) und das Obergehäuse (13) entlang einer ersten Richtung (X) der Reihe nach angeordnet sind; und
eine Projektion der Hitzeverteilungsplatte (11) entlang der ersten Richtung (X) zumindest einen Zielbereich der Leiterplatte (12) abdeckt;
wobei die Leiterplatte (12) einen primärseitigen Bereich und einen sekundärseitigen Bereich umfasst; der primärseitige Bereich ein Bereich ist, in dem sich eine DC-Schaltung der Leiterplatte (12) befindet, und der sekundärseitige Bereich ein Bereich ist, in dem sich eine AC-Schaltung der Leiterplatte (12) befindet;
der Zielbereich Folgendes umfasst:
einen ersten Bereich auf der Leiterplatte (12), wobei Bauelemente auf dem ersten Bereich einen Stromverbrauch aufweisen, der größer als ein erster vorbestimmter Schwellwert ist;
den primärseitigen Bereich auf der Leiterplatte (12), und
einen zweiten Bereich in dem sekundärseitigen Bereich, wobei Bauelemente auf dem zweiten Bereich einen Stromverbrauch aufweisen, der größer als ein zweiter vorbestimmter Schwellwert ist;
die Hitzeverteilungsplatte (11) eine durchgehende einstückige Hitzeverteilungsplatte ist und aus einem Metallmaterial gebildet ist;
eine erste Gruppe von Durchgangslöchern in der Hitzeverteilungsplatte (11) gebildet ist, und Projektionen der ersten Gruppe von Durchgangslöchern entlang der ersten Richtung (X) sich in dem primärseitigen Bereich befinden, und die erste Gruppe von Durchgangslöchern zur Isolierung ausgebildet ist;
die erste Gruppe von Durchgangslöchern ein Durchgangsloch des vierten Typs (34) und zumindest eines umfasst von Folgendem: einem Durchgangsloch des ersten Typs (31), einem Durchgangsloch des zweiten Typs (32), einem Durchgangsloch des dritten Typs (33) oder einem Durchgangsloch des fünften Typs (36);
eine Projektion des Durchgangslochs des ersten Typs (31) entlang der ersten Richtung (X) einem Anschlussstift eines Kommunikationstransformators in einer Powerline-Kommunikation (PLC) entspricht;
eine Projektion des Durchgangslochs des zweiten Typs (32) entlang der ersten Richtung (X) einem Anschlussstift eines Kondensators entspricht;
eine Projektion des Durchgangslochs des dritten Typs (33) entlang der ersten Richtung (X) einem Steckverbinder entspricht;
eine Projektion des Durchgangslochs des vierten Typs (34) entlang der ersten Richtung (X) einem Anschlussstift des Transformators in dem primärseitigen Bereich entspricht;
eine Projektion des Durchgangslochs des fünften Typs (36) entlang der ersten Richtung (X) einem Abtastanschlussstift eines Stromwandlers (CT) entspricht;
eine zweite Gruppe von Durchgangslöchern in der Hitzeverteilungsplatte (11) gebildet ist, Projektionen der zweiten Gruppe von Durchgangslöchern entlang der ersten Richtung (X) sich in dem sekundärseitigen Bereich befinden, und die zweite Gruppe von Durchgangslöchern Anschlussstiften von Bauelementen in dem sekundärseitigen Bereich entspricht, so dass die Bauelemente auf dem primärseitigen Bereich von den Bauelementen auf dem sekundärseitigen Bereich durch einen Sicherheitsabstand getrennt sind; und
die zweite Gruppe von Durchgangslöchern ein Durchgangsloch des sechsten Typs (35) umfasst; und eine Projektion des Durchgangslochs des sechsten Typs (35) entlang der ersten Richtung (X) einem Anschlussstift des Transformators in dem sekundärseitigen Bereich entspricht.

2. Elektronische Vorrichtung nach Anspruch 1, wobei ein Filterschaltungsbereich für elektromagnetische Interferenz (EMI) (45) in dem sekundärseitigen Bereich auf der Leiterplatte (12) außerhalb des Zielbereichs angeordnet ist.

3. Elektronische Vorrichtung nach Anspruch 1, wobei ein Transformator in dem Zielbereich angeordnet ist, und der Transformator zwischen dem primärseitigen Bereich und dem sekundärseitigen Bereich verbunden ist.

4. Elektronische Vorrichtung nach Anspruch 1, wobei die Hitzeverteilungsplatte (11) einen Beschichtungsbereich mit wärmeleitendem Klebstoff umfasst, und eine Projektion des Beschichtungsbereichs mit wärmeleitendem Klebstoff entlang der ersten Richtung (X) sich mit Bauelementbereichen mit hohem Stromverbrauch deckt.

5. Elektronische Vorrichtung nach Anspruch 4, wobei der Beschichtungsbereich mit wärmeleitendem Klebstoff einen ersten Beschichtungsbereich (421) und einen zweiten Beschichtungsbereich (422) umfasst;
eine Projektion des ersten Beschichtungsbereichs (421) entlang der ersten Richtung (X) sich mit einem Bauelementbereich mit hohem Stromverbrauch (431) in dem primärseitigen Bereich deckt; und
eine Projektion des zweiten Beschichtungsbereichs (422) entlang der ersten Richtung (X) sich mit einem Bauelementbereich mit hohem Stromverbrauch (432) in dem sekundärseitigen Bereich deckt.

6. Elektronische Vorrichtung nach Anspruch 5, wobei ein erster Vorsprung (441) und ein zweiter Vorsprung (442) auf der Hitzeverteilungsplatte (11) angeordnet sind; der erste Beschichtungsbereich (421) auf dem ersten Vorsprung (441) angeordnet ist, und der zweite Beschichtungsbereich (422) auf dem zweiten Vorsprung (442) angeordnet ist.

7. Elektronische Vorrichtung nach Anspruch 1, wobei die Hitzeverteilungsplatte (11) mit einem Vorsprung bereitgestellt ist, und eine Projektion des Vorsprungs entlang der ersten Richtung (X) sich mit einem Bauelementbereich mit hohem Stromverbrauch deckt.

8. Elektronische Vorrichtung nach Anspruch 1, wobei eine Dicke der Hitzeverteilungsplatte (11) größer als oder gleich 2 mm ist.

9. Elektronische Vorrichtung nach Anspruch 1, wobei ein erster Positionierpfosten (51) an einer Seite des Untergehäuses (14) nahe der Hitzeverteilungsplatte (11) angeordnet ist und dazu angepasst ist, sich entlang der ersten Richtung (X) zu erstrecken; ein erstes Positionierloch (52) in der Hitzeverteilungsplatte (11) gebildet ist, ein Begrenzungsloch (53) in der Leiterplatte (12) gebildet ist, und der erste Positionierpfosten (51) dazu angepasst ist, nacheinander durch das erste Positionierloch (52) und das Begrenzungsloch (53) hindurchzugehen.

10. Elektronische Vorrichtung nach Anspruch 9, wobei der erste Positionierpfosten (51) einen Stützsockel (511) umfasst, die Leiterplatte (12) von dem Stützsockel (511) gestützt wird, und eine Höhe des Stützsockels (511) größer als eine Dicke der Hitzeverteilungsplatte (11) ist.

11. Elektronische Vorrichtung nach Anspruch 1, wobei ein zweiter Positionierpfosten (54) an dem Untergehäuse (14) angeordnet ist, ein zweites Positionierloch (55) an der Hitzeverteilungsplatte (11) gebildet ist, der zweite Positionierpfosten (54) dazu angepasst ist, in das zweite Positionierloch (55) eingesetzt zu werden, und eine Höhe des zweiten Positionierpfostens (54) dieselbe wie eine Dicke der Hitzeverteilungsplatte (11) ist.

## Revendications

1. Dispositif électronique, le dispositif électronique comprenant un boîtier, une plaque (11) d'étalement thermique et une carte à circuit (12) ;
le boîtier comprend un boîtier supérieur (13) et un boîtier inférieur (14) ; le boîtier inférieur (14), la plaque (11) d'étalement thermique, la carte à circuit (12) et le boîtier supérieur (13) sont disposés dans cet ordre selon une première direction (X) ; et
une projection de la plaque (11) d'étalement thermique selon la première direction (X) couvre au moins une zone cible de la carte à circuit (12) ;
dans lequel la carte à circuit (12) comprend une zone du côté primaire et une zone du côté secondaire ; la zone du côté primaire est une zone où un circuit à courant continu de la carte à circuit (12) est situé, et la zone du côté secondaire est une zone où un circuit à courant alternatif de la carte à circuit (12) est situé ;
la zone cible comprend :
une première zone sur la carte à circuit (12), dans laquelle des composants sur la première zone présentent une consommation de puissance supérieure à un premier seuil prédéfini ;
la zone du côté primaire sur la carte à circuit (12), et
une deuxième zone dans la zone du côté secondaire, dans laquelle des composants sur la deuxième zone présentent une consommation de puissance supérieure à un deuxième seuil prédéfini ;
la plaque (11) d'étalement thermique est une plaque d'étalement thermique continue d'un seul tenant et est constituée d'un matériau métallique ;
un premier groupe de trous traversants est formé dans la plaque (11) d'étalement thermique, et des projections du premier groupe de trous traversants selon la première direction (X) sont situées dans la zone du côté primaire, et le premier groupe de trous traversants est configuré pour l'isolation ;
le premier groupe de trous traversants comprend un trou traversant de quatrième type (34) et au moins un parmi : un trou traversant de premier type (31), un trou traversant de deuxième type (32), un trou traversant de troisième type (33), ou un trou traversant de cinquième type (36) ;
une projection du trou traversant de premier type (31) selon la première direction (X) correspond à une broche de transformateur de communication dans une communication par courant porteur en ligne (PLC) ;
une projection du trou traversant de deuxième type (32) selon la première direction (X) correspond à une broche de condensateur ;
une projection du trou traversant de troisième type (33) selon la première direction (X) correspond à un connecteur ;
une projection du trou traversant de quatrième type (34) selon la première direction (X) correspond à une broche du transformateur dans la zone du côté primaire ;
une projection du trou traversant de cinquième type (36) selon la première direction (X) correspond à une broche d'échantillonnage d'un transformateur de courant (CT) ;
un deuxième groupe de trous traversants est formé dans la plaque (11) d'étalement thermique, des projections du deuxième groupe de trous traversants selon la première direction (X) sont situées dans la zone du côté secondaire, et le deuxième groupe de trous traversants correspond à des broches de composants dans la zone du côté secondaire, de sorte que les composants sur la zone du côté primaire sont séparés des composants sur la zone du côté secondaire par une distance de sécurité ; et
le deuxième groupe de trous traversants comprend un trou traversant de sixième type (35) ; et une projection du trou traversant de sixième type (35) selon la première direction (X) correspond à une broche du transformateur dans la zone du côté secondaire.

2. Dispositif électronique selon la revendication 1, dans lequel une zone (45) de circuit de filtrage des interférences électromagnétiques (EMI) dans la zone du côté secondaire sur la carte à circuit (12) est située en dehors de la zone cible.

3. Dispositif électronique selon la revendication 1, dans lequel un transformateur est agencé dans la zone cible, et le transformateur est raccordé à travers la zone du côté primaire et la zone du côté secondaire.

4. Dispositif électronique selon la revendication 1, dans lequel la plaque (11) d'étalement thermique comprend une zone de revêtement d'adhésif thermoconducteur, et une projection de la zone de revêtement d'adhésif thermoconducteur selon la première direction (X) coïncide avec des zones de composants à consommation de puissance élevée.

5. Dispositif électronique selon la revendication 4, dans lequel la zone de revêtement d'adhésif thermoconducteur comprend une première zone de revêtement (421) et une deuxième zone de revêtement (422) ;
une projection de la première zone de revêtement (421) selon la première direction (X) coïncide avec une zone de composants à consommation de puissance élevée (431) dans la zone du côté primaire ; et
une projection de la deuxième zone de revêtement (422) selon la première direction (X) coïncide avec une zone de composants à consommation de puissance élevée (432) dans la zone du côté secondaire.

6. Dispositif électronique selon la revendication 5, dans lequel une première saillie (441) et une deuxième saillie (442) sont aménagées sur la plaque (11) d'étalement thermique ; la première zone de revêtement (421) est disposée sur la première saillie (441), et la deuxième zone de revêtement (422) est disposée sur la deuxième saillie (442).

7. Dispositif électronique selon la revendication 1, dans lequel la plaque (11) d'étalement thermique est munie d'une saillie, et une projection de la saillie selon la première direction (X) coïncide avec une zone de composants à consommation de puissance élevée.

8. Dispositif électronique selon la revendication 1, dans lequel une épaisseur de la plaque (11) d'étalement thermique est supérieure ou égale à 2 mm.

9. Dispositif électronique selon la revendication 1, dans lequel un premier pion de positionnement (51) est disposé sur un côté du boîtier inférieur (14) proche de la plaque (11) d'étalement thermique et est adapté à s'étendre selon la première direction (X) ;
un premier trou de positionnement (52) est formé dans la plaque (11) d'étalement thermique, un trou de limitation (53) est formé dans la carte à circuit (12), et le premier pion de positionnement (51) est adapté à passer à travers le premier trou de positionnement (52) et le trou de limitation (53), dans cet ordre.

10. Dispositif électronique selon la revendication 9, dans lequel le premier pion de positionnement (51) comprend un socle de support (511), la carte à circuit (12) est supportée sur le socle de support (511), et une hauteur du socle de support (511) est supérieure à une épaisseur de la plaque (11) d'étalement thermique.

11. Dispositif électronique selon la revendication 1, dans lequel un deuxième pion de positionnement (54) est disposé sur le boîtier inférieur (14), un deuxième trou de positionnement (55) est formé sur la plaque (11) d'étalement thermique, le deuxième pion de positionnement (54) est adapté à être inséré dans le deuxième trou de positionnement (55), et une hauteur du deuxième pion de positionnement (54) est identique à une épaisseur de la plaque (11) d'étalement thermique.
